# EUROPEAN PATENT SPECIFICATION

(11) **EP 0 300 173 B1**
(45) Date of publication and mention of the grant of the patent: **25.08.1993**
(21) Application number: 88108635.9
(22) Date of filing: 30.05.1988
(51) Int. Cl.: H03D 7/16, H03J 5/24

(54) **Outdoor unit low noise converter for satellite broadcast reception use**
Rauscharme Umsetzereinheit für den Empfang von Satelliten-Rundfunk und Betrieb in Freien
Unité externe et convertisseur faible bruit pour utilisation à la réception de la radiodiffusion par satellites

(30) Priority: 24.07.1987 JP 185877/87; 27.07.1987 JP 115478/87 U
(43) Date of publication of application: 25.01.1989
(73) Proprietor: SHARP KABUSHIKI KAISHA, Osaka 545 (JP)
(72) Inventor: Yamauchi, Miyoshi, Osaka-shi Osaka-fu (JP); Noboru, Mitsuhiro, Minamikawachi-gun Osaka-fu (JP)
(74) Representative: TER MEER STEINMEISTER & PARTNER GbR

(56) References cited:
- EP-A- 0 149 533
- US-A- 4 509 198
- 13th INT. TV SYMPOSIUM, Montreux, 28th May - 2nd June 1983, pages 252-255; J.G. CHAPLIN et al.: "European satellite broadcasting. The case for an FM television receiver"

## Description

The present invention relates to a multiple-band low noise converter as used in outdoor reception of satellite broadcast signals.

The document EP-A-0 149 533 describes a converter of the above type, said converter comprising:
- a wide-band low noise amplifier;
- a mixing means comprising local oscillator means, said mixing means outputting an IF signal to an IF output terminal; and
- switching means for switching between different frequencies of said local oscillator means, each frequency determining a frequency band to be received.

In this prior art converter, the mixing means comprises a single voltage controlled oscillator as local oscillator. The control voltage for adjusting the frequency of the local oscillator is adjusted in relation with a control voltage supplied to the IF output terminal.

It is the object of the present invention to provide a converter having simple construction and having the function of the above discussed prior art converter.

The converter of the present invention is characterized in that
- a power divider is arranged at the output side of said wide-band low noise amplifier for distributing the output signal of said amplifier into different branches;
- said mixing means comprises a bandpass filter and a mixer with a local oscillator in each branch, the frequency of said local oscillator being allocated to the pass characteristic of said bandpass filter in a way that the output signal is within a certain band of the IF signal; and
- said switching means is arranged to selectively switch one of the outputs of said mixers to the output terminal of said converter.

This converter has simple construction, as no mixers and oscillators operating in a broader band are necessary, but as only oscillators operating at a fixed frequency and mixers operating in a narrow band, as fixed by the bandpass filter in each branch, are required.

These an other objects and features of the present invention will become clear from the following description taken in conjunction with the preferred embodiments thereof with reference to the accompanying drawings, in which:
Fig. 1 is a circuit diagram of a two-band low noise converter according to a first embodiment of the present invention;
Fig. 2 is a graph showing the relationship between two bands received with the converter according to Fig. 1;
Fig. 3 is a circuit diagram of a converter according to a second embodiment of the present invention, in which embodiment a voltage for band switching is supplied via the IF output terminal of the converter;
Fig. 4 is a diagram of a circuit for adjusting a threshold voltage;
Fig. 5 is a plan view onto a converter equipped with the circuit according to Fig. 3; and
Fig. 6 is a diagram to illustrate band selection by using a control voltage and the threshold voltage as adjusted e. g. with the circuit of Fig. 4.

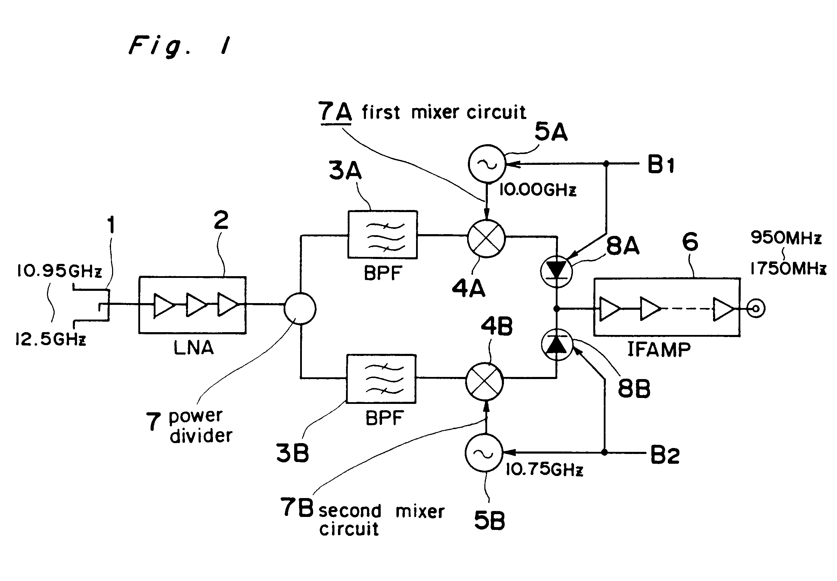

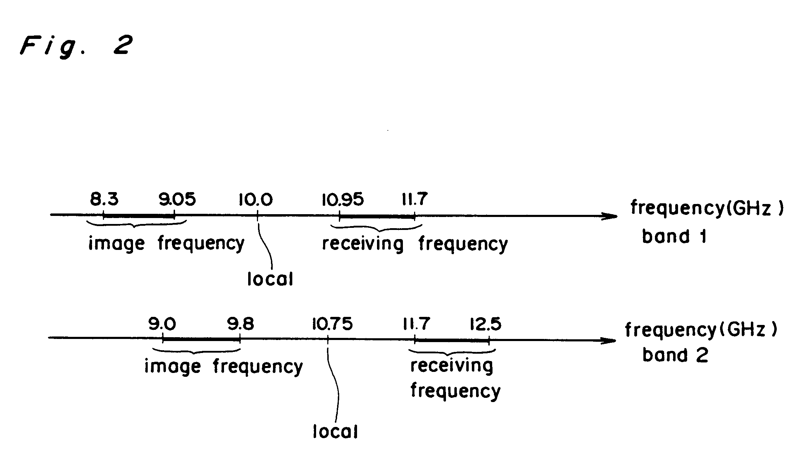

The circuit construction in a first embodiment of the present invention is shown in Fig. 1. Fig. 2 shows the frequency relation of a plurality of bands to be received. Here, the ECS band of 10.95 GHz through 11.7 GHz and the Europe Ku band of 11.7 GHz through 12.5 GHz, two bands, are switched for reception.

A low noise amplifier 2 has a wide band so that the signals of 10.95 GHz through 12.5 GHz may be amplified. A power divider 7 divides the amplified output signal into two for connection to each of a first band passing type filter 3A with, for example, 10.95 GHz through 11.7 GHz being a passing band and, a second band passing type filter 3B with, for example, 11.7 through 12.5 GHz being a passing band. A first mixer circuit 7A composed of a mixer 4A and a local oscillator 5A of a 10.00 GHz is connected to the first band passing type filter 3A, and a second mixer circuit 7B composed of a mixer 4B and a local oscillator 5B of 10.75 GHz is connected to the second band passing type filter 3B.

The output switching operation into the after IF amplifier 6 is selected in relation with the control of the oscillating operation of the respective local oscillator 5A, 5B with voltages B1, B2 as power supply, and diode switches 8A, 8B connected in series respectively to mixers 4A, 4B. It is to be noted that diode switches 8A, 8B are adapted to turn on, off through the operative cooperation in common with the controlling operation of the local oscillators with the voltages B1, B2.

In the first mixer circuit 7A, the signals of 10.95 GHz through 11.7 GHz which have passed through the first band passing type filter A are converted into the frequencies of 950 MHz through 1700 MHz (750 MHz in band width). In the second mixer circuit 7B, similarly the signals of 11.7 GHz through 12.5 GHz which have passed through the second band passing filter 3B are converted into the frequencies of 950 MHz through 1750 MHz (800 MHz in band width). In this manner, frequencies are selectively outputted into the IF amplifier 6 within the range of 950 MHz through 1750 MHz, with the band width not being made larger and being within the range of 750 MHz through 800 MHz.

In the above description, two bands are provided; more bands may be used.

In the first embodiment of the present invention, a useful low noise converter for satellite broadcasting reception is provided, which is capable of receiving a plurality of bands by one converter for frequency converting operation.

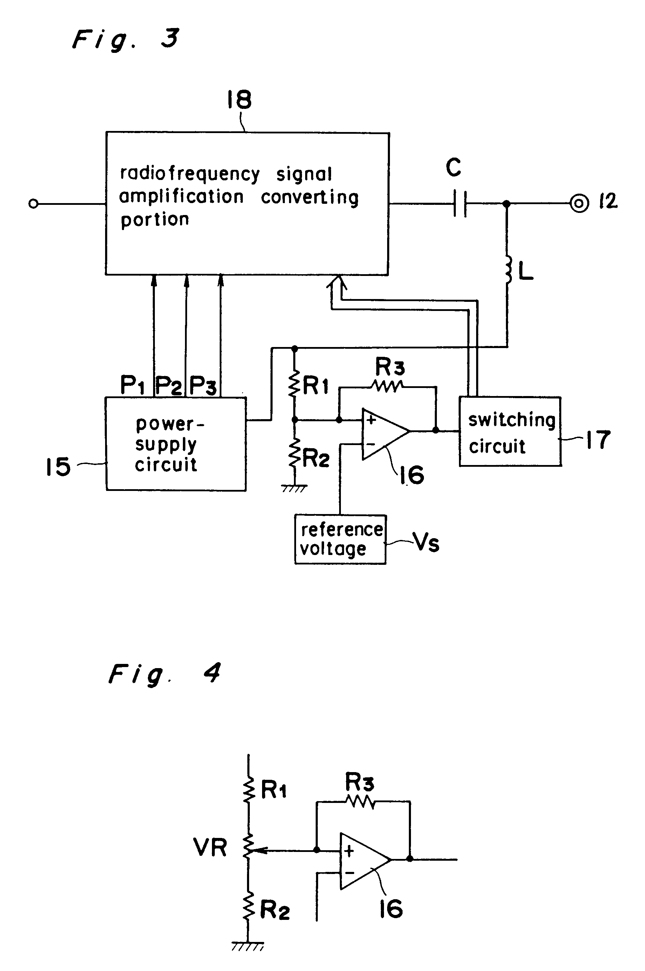

The second embodiment of the present invention will be fully described with reference to Figs. 3 through 6.

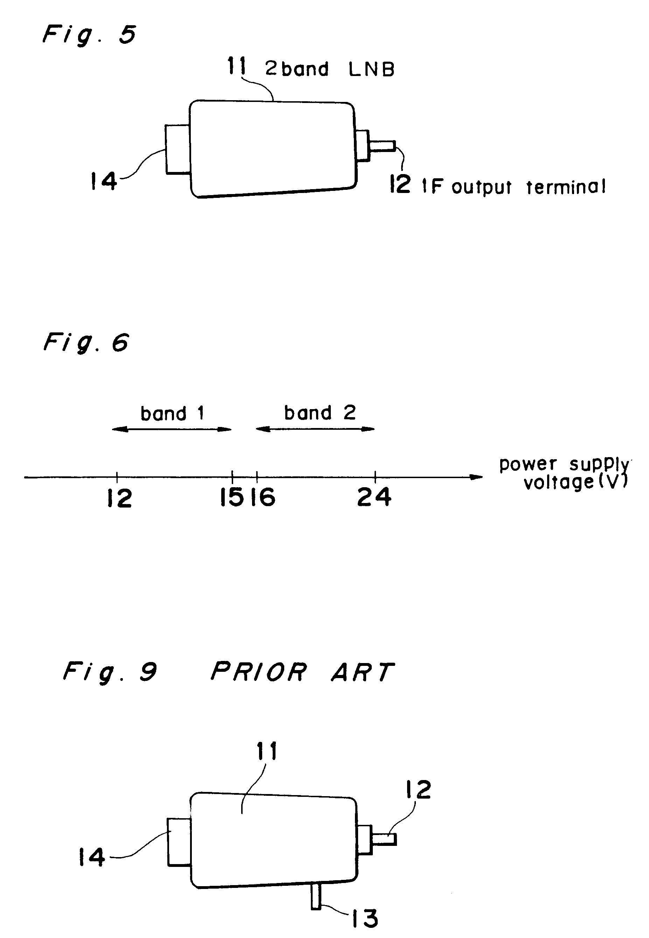

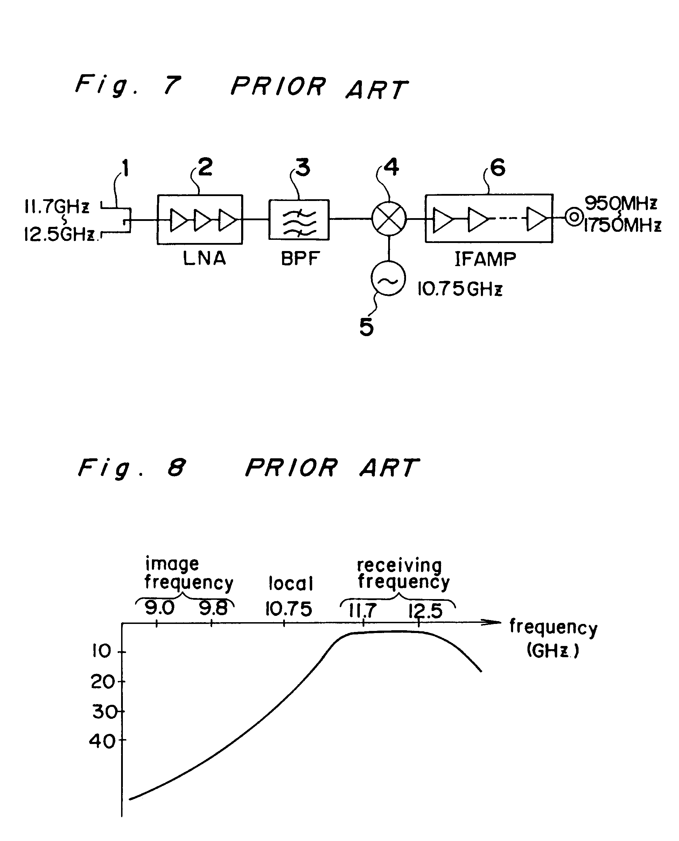

Fig. 5 shows an appearance view of a 2-band LNB1 in accordance with the present invention. Referring to Fig. 5, external terminals are an input waveguide 14 (generally the input terminal is made of a waveguide, but may be made of a coaxial cable instead) to be connected with an antenna and an IF output terminal 12 only. Accordingly, the airtight construction does not change because of the two bands. The IF output terminal 12 serves also as a power supply.

Band switching will be described by use of the circuit diagram of Fig. 3. Referring to Fig. 3, the power supply voltage to be supplied through the IF output terminal 12 is drawn out by a coil L to be supplied to a power supply circuit 15. It is divided by resistors R1, R2 to be compared with a reference voltage Vs by a comparator 16; the output is inputted to the switching circuit 17 such as a relay or the like. As shown in Fig. 6, in the switching circuit 17, a band 1 is selected if the voltage is 12 through 15V, a band 2 is selected if the voltage is 16 through 24V, with, for example, 15 through 16V being a threshold voltage (boundary). The power supply circuit 15 is composed of a three-terminal regulator outputting voltages P1, P2, P3 to a radio frequency signal amplification converting portion 18, the outputs P1 through P3 being provided as -3V, 5B, 12V. It is to be noted that C is a capacitor for DC cut use, R3 is a resistor which causes hysteresis characteristics so as to prevent the output of the comparator from being unstable near the threshold voltage.

Also, as shown in Fig. 4, a variable resistor VR is inserted for adjustment in order to prevent a variation of the threshold voltage caused by a variation of the reference voltage Vs.

According to the second embodiment of the present invention, a useful 2-band LNB is provided which is capable of receiving two frequency bands by one LNB to simplify the construction and to reduce the cost, and also is higher in airtightness to simplify the construction of the LNB itself.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A multiple-band low noise converter for outdoor satellite broadcast reception comprising
- a wide-band low noise amplifier (2);
- a mixing means (7A, 7B) comprising local oscillator means (5A, 5B), said mixing means outputting an IF signal to an IF output terminal (12); and
- switching means (17; 8A, 8B; B1, B2) for switching between different frequencies of said local oscillator means, each frequency determining a frequency band to be received;
**characterized in that**
- a power divider (7) is arranged at the output side of said wide-band low noise amplifier (2) for distributing the output signal of said amplifier into different branches;
- said mixing means comprises, in each of said branches, a bandpass filter (3A, 3B) and a mixer (4A, 4B) with a local oscillator (5A, 5B), the frequency of said local oscillator being allocated to the pass characteristic of said bandpass filter in a way that the output signal is within a certain band of the IF signal; and
- said switching means (17; 8A, 8B; B1, B2) is arranged to selectively switch one of the outputs of said mixers to the output terminal of said converter.

2. A converter according to claim 1, **characterized in that** said switching means (17) activates only the local oscillator (5A, 5B) within the selected branch.

3. A converter according to one of the claims 1 or 2, **characterized in that**
- said IF output terminal (12) serves as a power supply; and
- said switching means (17) is responsive to the voltage as applied to said IF output terminal, to switch between said different branches depending on the value of said voltage.

## Patentansprüche

1. Rauscharme Mehrbandumsetzereinheit für den Empfang von Satelliten-Rundfunk im Freien, mit:
- einem breitbandigen, rauscharmen Verstärker (2);
- einer Mischeinrichtung (7A, 7B), die eine Ortsoszillatoreinrichtung (5A, 5B) aufweist, welche Mischeinrichtung ein ZF-Signal an einen ZF-Ausgangsanschluß (12) ausgibt; und
- einer Umschalteinrichtung (17; 8A, 8B; B1, B2) zum Umschalten zwischen verschiedenen Frequenzen der Ortsoszillatoreinrichtung, wobei jede Frequenz ein zu empfangendes Frequenzband bestimmt;
**dadurch gekennzeichnet,** daß
- ein Leistungsverteiler (7) an der Ausgangsseite des breitbandigen, rauscharmen Verstärkers (2) angeordnet ist, um das Ausgangssignal des Verstärkers auf zwei verschiedene Zweige zu verteilen;
- die Mischeinrichtung in jedem der Zweige ein Bandpaßfilter (3A, 3B) und einen Mischer (4A, 4B) mit einem Ortsoszillator (5A, 5B) aufweist, wobei die Frequenz des Ortsoszillator der Durchgangscharakteristik des Bandpaßfilters auf solche Weise zugeordnet ist, daß das Ausgangssignal in einem bestimmten Band des ZF-Signals liegt; und
- die Umschalteinrichtung (17; 8A, 8B; B1, B2) so ausgebildet ist, daß sie wahlweise einen der Ausgänge des Mischers auf den Ausgangsanschluß der Umsetzereinheit schaltet.

2. Umsetzereinheit nach Anspruch 1, **dadurch gekennzeichnet,** daß die Umschalteinrichtung (17) nur den Ortsoszillator (5A, 5B) im ausgewählten Zweig aktiviert.

3. Umsetzereinheit nach einem der Ansprüche 1 oder 2, **dadurch gekennzeichnet,** daß
- der ZF-Ausgangsanschluß (12) als Spannungsversorgung dient; und
- die Umschalteinrichtung (17) auf die Spannung anspricht, wie sie an den ZF-Ausgangsanschluß gelegt wird, um abhängig vom Wert dieser Spannung zwischen den verschiedenen Zweigen umzuschalten.

## Revendications

1. Convertisseur multibande à faible bruit pour la réception à l'extérieur de la radiodiffusion par satellite, comprenant :
- un amplificateur à large bande à faible bruit (2) ;
- un moyen mélangeur (7A, 7B) comprenant des moyens d'oscillateur local (5A, 5B), ledit moyen mélangeur fournissant un signal FI (à fréquence intermédiaire) à une borne de sortie FI (12) ; et
- un moyen commutateur (17 ; 8A, 8B ; B1, B2) pour commuter entre différentes fréquences desdits moyens d'oscillateur local, chaque fréquence déterminant une bande de fréquences à recevoir ;
**caractérisé en ce que**
- un diviseur de puissance (7) est disposé du côté sortie dudit amplificateur à large bande à faible bruit (2) pour distribuer le signal de sortie dudit amplificateur dans différentes branches ;
- ledit moyen mélangeur comprend, dans chacune desdites branches, un filtre passe-bande (3A, 3B) et un mélangeur (4A, 4B) avec un oscillateur local (5A, 5B), la fréquence dudit oscillateur local étant attribuée à la caractéristique passante dudit filtre passe-bande de telle manière que le signal de sortie se situe dans une certaine bande du signal FI ; et
- ledit moyen commutateur (17 ; 8A, 8B ; B1, B2) est agencé de manière à sélectivement commuter l'une des sorties desdits mélangeurs vers la borne de sortie dudit convertisseur.

2. Convertisseur selon la revendication 1, **caractérisé en ce que** ledit moyen commutateur (17) active uniquement l'oscillateur local (5A, 5B) dans la branche sélectionnée.

3. Convertisseur selon l'une quelconque des revendications 1 ou 2, **caractérisé en ce que**
- ladite borne de sortie FI (12) fait fonction d'alimentation ; et
- ledit moyen commutateur (17) réagit à la tension, telle qu'appliquée à ladite borne de sortie FI, pour commuter entre les différentes branches, en fonction de la valeur de ladite tension.
